Europäisches Patentamt

European Patent Office

Office européen des brevets

(11) Veröffentlichungsnummer: **0 480 206 A2**

# EUROPÄISCHE PATENTANMELDUNG

(21) Anmeldenummer: **91115656.0**

(22) Anmeldetag: **16.09.91**

(51) Int. Cl.⁵: **G01R 31/308**, G01R 1/067

(30) Priorität: **09.10.90 DE 4032031**

(43) Veröffentlichungstag der Anmeldung:
**15.04.92 Patentblatt 92/16**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Sölkner, Gerald, Dr.**
**Naupliaallee 12**
**W-8012 Ottobrunn(DE)**

(54) **Verfahren zur optischen Messung elektrischer Potentiale.**

(57) Die optische Absorptionskante eines Halbleiters wird in einem elektrischen Feld zu kleineren Photonenenergien verschoben. Das erfindungsgemäße Verfahren nutzt diesen elektroabsorptiven Effekt, um elektrische Signale in Bauelementen der Mikroelektronik auf optischem Wege zu messen. Als Meßsensor (MS) dient ein unmittelbar oberhalb des Bauelements (DUT) angeordneter und von einem Laserstrahl (LA) abgetasteter plattenförmiger Körper. Dieser besteht aus einem für die verwendete Strahlung (LA) transparenten Trägerkristall (TK), einer ebenfalls transparenten leitfähigen Schicht (TL) und einem probenseitig dielektrisch verspiegelten Halbleiter (HL), dessen Absorptionsverhalten durch die von den Leiterbahnen (LB) ausgehenden elektrischen Streufelder (SF) beeinflußt wird. Meßgröße ist die Intensität der am dielektrischen Spiegel (DS) reflektierten und in Richtung einer Photodiode umgelenkten Laserstrahlung.

FIG 1

Die Erfindung betrifft ein Verfahren zur optischen Messung elektrischer Potentiale.

Das aus Electronics Letters Vol. 21, No. 13 (1985) Seiten 568 bis 569 bekannte Verfahren verwendet eine einseitig dielektrisch verspiegelte Kristallplatte mit elektrooptischen Eigenschaften, um die Potentialverteilung in Bauelementen der Mikroelektronik mit Hilfe einer Lasersonde abzubilden. Da man den von der Sonde punktweise abgetasteten Meßsensor unmittelbar oberhalb des Bauelements anordnet, können die von den Leiterbahnen ausgehenden elektrischen Streufelder in den Kristall eindringen und in diesem Doppelbrechung induzieren. Die hierdurch bedingte Änderung der Polarisation der den Kristall im Streufeldbereich durchsetzenden Laserstrahlung wird in einer Analysatoreinheit nachgewiesen und in Abhängigkeit vom Ort des Laserfokus auf der Bauelementoberfläche aufgezeichnet.

Während die aus Electr. Lett. Vol. 20, Nr. 20 (1984), Seiten 818 - 819, Appl. Phys. Lett. 47 (10), 1985, Seiten 1083 bis 1084 und US-A-4 681 449 bekannten Meßverfahren die elektrooptischen Eigenschaften des Substratmaterials zur Aufzeichnung von Signalpegeländerungen in Ga-As-Schaltungen ausnutzen, verwendet das in Electronics Letters, Vol. 22, No. 17 (1986), Seiten 918 bis 919 und US-A-4 618 819 beschriebene Verfahren eine $LiTaO_3$-Kristallspitze, um die im Bereich der Leiterbahnen auftretenden elektrischen Felder mit Hilfe einer die Kristallspitze durchsetzenden Lasersonde stroboskopisch abzutasten.

Weitere Lasermeßverfahren werden in IEEE Journal of Quantum Electronics Vol. 22, No. 1, (1986), Seiten 69 bis 78 beschrieben.

Der Erfindung liegt die Aufgabe zugrunde, ein Verfahren der eingangs genannten Art anzugeben, mit dem Potentiale insbesondere in Bauelementen der Mikroelektronik mit großer Genauigkeit gemessen werden können. Diese Aufgabe wird erfindungsgemäß durch ein Verfahren mit den Merkmalen des Patentanspruchs 1 gelöst.

Der mit der Erfindung erzielbare Vorteil besteht insbesondere darin, daß die Zeitabhängigkeit elektrischer Potentiale unbeeinflußt von der Oberflächenstruktur im Bereich der Meßstelle bestimmt werden kann.

Die abhängigen Ansprüche betreffen vorteilhafte Weiterbildungen des im folgenden anhand der Zeichnung erläuterten Verfahrens. Hierbei zeigt:

Fig. 1    einen Querschnitt durch den oberhalb des zu untersuchenden Bauelements angeordneten Meßsensor

Fig. 2    den schematischen Aufbau einer Vorrichtung zur Durchführung des Verfahrens

Die optische Absorptionskante eines Halbleiters wird in einem elektrischen Feld zu kleineren Photonenenergien verschoben (Franz-Keldysh-Effekt). Das erfindungsgemäße Verfahren nutzt diesen elektroabsorptiven Effekt, um elektrische Potentiale auf optischem Wege mit Hilfe einer Lasersonde zu messen. Eine merkliche Schwächung monochromatischen Lichtes der Energie $E_{Ph} \lesssim E_B$ ($E_B$ : Bandabstand des Halbleiters) beobachtet man allerdings erst bei hohen Feldstärken von etwa 10 kV/cm. Da elektrische Felder dieser Größenordnung in Sub-Mikrometerstrukturen auch bei niedrigen Potentialen auftreten, eignet eignet sich das erfindungsgemäße Verfahren insbesondere zur Messung schneller Signalpegeländerungen an Leiterbahnen moderner VLSI-Schaltungen.

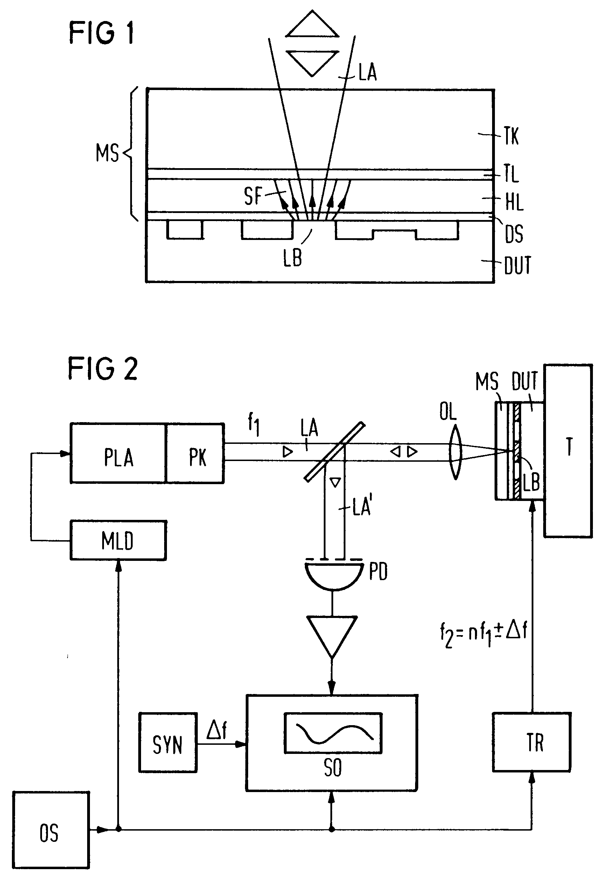

Als Meßsensor dient der in Fig. 1 dargestellte plattenförmige Körper MS, den man unmittelbar oberhalb des Bauelements DUT anordnet und mit einem Laserstrahl LA abtastet. Der Meßsensor MS besteht aus einem für die verwendete Strahlung LA transparenten YAG-Trägerkristall TK, einer ebenfalls transparenten leitfähigen Schicht TL (beispielsweise Zinnoxyd) und einer probenseitig dielektrisch verspiegelten Schicht undotierten Halbleitermaterials HL, deren Absorptionsverhalten durch die von den Leiterbahnen LB ausgehenden elektrischen Streufelder SF beeinflußt wird. Als Halbleitermaterialien kommen insbesondere CdS (Absorption bei 0,5 $\mu$m) und ZnS (Absorption bei 0,3 $\mu$m) in Betracht. Zu verwenden sind selbstverständlich auch andere einkristalline Halbleiter, die eine definierte Bandkante besitzen.

Die Abmessungen und Dicken der Sensorkomponenten sind den experimentiellen Gegebenheiten anzupassen. Für die Untersuchung eines Bauelements DUT mit einer aktiven Oberfläche von etwa 1 x 1 cm$^2$ haben sich folgende Schichtdicken d als vorteilhaft herausgestellt.

| | |
|---|---|
| Trägerkristall TK | $d_{TK} \approx 0,5$ mm |
| leitfähige Schicht TL | $d_{TL} \approx 100$ nm |
| Halbleiterschicht HL | $d_{HL} \gtrsim 50\ \mu$m |
| dielektrischer Spiegel DS | $d_{DS} \approx 10\ \mu$m |

Der Meßsensor MS sollte möglichst nahe an das Bauelement DUT herangebracht, insbesondere auf dessen Oberfläche aufgelegt werden, so daß die elektrischen Streufelder SF den Halbleiter HL oberhalb der signalführenden Komponenten LB nahezu senkrecht durchsetzen. Das Absorptionsverhalten des Halbleiters HL ist dann nur noch vom jeweiligen Leiterbahnpotential bzw. von der zwischen der Leiterbahn HL und der leitfähigen Schicht TL aufgebauten Potentialdifferenz abhängig. Signalpegeländerungen lassen sich daher unbeeinflußt von der Struktur der Oberfläche im Bereich der Meßstelle mit Hilfe einer auf der interessierenden Leiterbahn LB positionierten Lasersonde LA bestimmen. Meßgröße ist hierbei die Intensität der am dielektrischen Spiegel DS reflektierten und in Richtung eines Detektors umgelenkten Strahlung (s. Fig. 2). Als Detektor dient eine Photodiode PD, deren Ausgangssignal verstärkt und in einem Sampling-Oszilloskop SO (Le Croy 9400) weiterverarbeitet wird.

Der sondenformende Teil der Vorrichtung besteht aus einer durchstimmbaren Pikosekunden-Laserquelle PLA (Impulswiederholfrequenz $f_1$ = 82 MHz, Impulsbreite $\tau \approx$ 100 ps), einem Impulskompressor PK zur Verringerung der Breite der Laserimpulse auf $\tau$ < 10 ps sowie einer optischen Einheit OL, die die Laserstrahlung LA auf die interessierende Leiterbahn LB des auf einem Positioniertisch T angeordneten Bauelements DUT fokussiert. Die Wellenlänge der von der Laserquelle PLA emittierten Strahlung LA wird hierbei so auf die Absorptionskante des im Meßsensor MS verwendeten Halbleiters HL abgestimmt, daß jede Änderung des Leiterbahnpotentials eine möglichst große Änderung der Intensität der reflektierten Laserstrahlung LA' hervorruft. Dies ist insbesondere dann gewährleistet, wenn die Photonenenergie kleiner und annähernd gleich ist dem Bandabstand des Halbleiters HL. Selbstverständlich kann man auch die energetische Lage der Absorptionskante durch Änderung des Potentials der leitfähigen Schicht TL auf die Wellenlänge der Laserstrahlung LA abstimmen.

Des weiteren enthält die Vorrichtung zur Durchführung des Verfahrens eine Treibereinheit TR, die das Bauelement DUT zur periodischen Abarbeitung eines Testprogramms veranlaßt. Falls die durch die Treibereinheit TR vorgebbare Ansteuerfrequenz $f_2$ einem ganzzahligen Vielfachen n die Impulswiederholfrequenz $f_1$ der Strahlungsquelle PLA entspricht, tastet die Lasersonde LA die während eines Testzyklus auftretenden Leiterbahnsignale innerhalb jeder n-ten Periode phasenstarr ab (Stroboskopieprinzip). Um die Zeitabhängigkeit der Signale vollständig aufzuzeichnen, wird eine Ansteuerfrequenz $f_2$ = $nf_1 \pm \Delta f$ ($f_1 \gg \Delta f \approx$ 1 kHz) gewählt, so daß sich die Phasenlage der Laserimpulse bezüglich der Leiterbahnsignale kontinuierlich ändert.

Ein Signal mit der durch $\Delta f$ gegebenen Samplingfrequenz liegt auch am Referenzeingang des Oszilloskops SO an. Dieses Signal erzeugt man mit einem Synthesizer SYN, der ebenso wie die Treibereinheit TR und der die Laserquelle PLA ansteuernde "Mode-Locker" MLD durch das Ausgangssignal eines phasenstabilen Referenzoszillators OS synchronisiert wird.

Die Erfindung ist selbstverständlich nicht auf die beschriebenen Ausführungsbeispiele beschränkt. So kann man den impulsförmig emittierenden Laser PLA auch durch eine aus einem cw-Laser und einem elektrooptischen Modulator (Pockels-Zelle) bestehende Einheit ersetzen, wobei der dem Modulator zugeordnete Impulsgenerator wieder mit Hilfe des Referenzoszillators OS synchronisiert wird.

Zur leichteren Abstimmung der Wellenlänge der den Meßsensor MS abtastenden Sonde LA auf die Absorptionskante des Halbleiters HL kann es von Vorteil sein, einen frequenzverdoppelnden Kristall im Strahlengang zwischen dem Laser und dem Bauelement anzuordnen.

**Patentansprüche**

1. Verfahren zur optischen Messung elektrischer Potentiale,
   **dadurch gekennzeichnet,**
   - daß ein Halbleiterkörper (HL) in der Nähe eines das zu messende Potential aufweisenden Bereichs (LB) einer Probe (DUT) derart angeordnet wird, daß das von dem Bereich (LB) ausgehende elektrische Streufeld (SF) zumindest teilweise in den Halbleiterkörper (HL) eindringt
   - und daß die durch das elektrische Streufeld (SF) induzierte Änderung des Absorptionsverhaltens des Halbleiterkörpers (HL) mit Hilfe einer das elektrische Streufeld (SF) durchsetzenden monochromatischen Lichtsonde (LA) bestimmt wird.

2. Verfahren nach Anspruch 1,
   **dadurch gekennzeichnet,**
   daß die Verschiebung der Absorptionskante des Halbleitermaterials durch Messung der Intensität der Lichtsonde (LA) bestimmt wird.

3. Verfahren nach Anspruch 1 oder 2,
   **dadurch gekennzeichnet,**
   daß Licht verwendet wird, dessen Photonenenergie kleiner und annähernd gleich ist dem Bandabstand des Halbleitermaterials.

3

4. Verfahren nach einem der Ansprüche 1 bis 3,
**dadurch gekennzeichnet,**
daß die probenseitige Fläche des Halbleiterkörpers (HL) verspiegelt wird und daß die Lichtsonde (LA) den Halbleiterkörper (HL) annähernd senkrecht zur Probenoberfläche durchsetzt.

5. Verfahren nach einem der Ansprüche 1 bis 4,
**dadurch gekennzeichnet,**
daß die probenabgewandte Seite des Halbleiterkörpers (HL) mit einer für die verwendete Strahlung transparenten, leitfähigen Schicht (TL) versehen wird.

6. Verfahren nach Anspruch 5,
**dadurch gekennzeichnet,**
daß die elektrisch leitfähige Schicht (TL) mit einem einstellbaren Potential beaufschlagt wird.

7. Verfahren nach einem der Ansprüche 1 bis 6,
**dadurch gekennzeichnet,**
daß die Lichtsonde (LA) auf ein ein periodisches elektrisches Signal führendes Element (LB) der Probe (DUT) gerichtet und synchron mit dem Signal eingetastet wird und daß die Phasenlage der Lichtimpulse bezüglich des Signals geändert wird.

8. Verfahren nach einem der Ansprüche 1 bis 7,
**dadurch gekennzeichnet,**
daß ein durchstimmbarer Laser (PLA) als Lichtquelle verwendet wird.

## FIG 1

## FIG 2

$$f_2 = nf_1 \pm \Delta f$$